(19) Europäisches Patentamt
European Patent Office
Office européen des brevets

(11) **EP 4 564 682 A1**

(12) **EUROPEAN PATENT APPLICATION**

(43) Date of publication:
**04.06.2025 Bulletin 2025/23**

(21) Application number: **23307070.5**

(22) Date of filing: **28.11.2023**

(51) International Patent Classification (IPC):
**H03L 7/091** $^{(2006.01)}$ **H03L 7/093** $^{(2006.01)}$
**H03L 7/099** $^{(2006.01)}$

(52) Cooperative Patent Classification (CPC):
**H03L 7/099; H03L 7/091; H03L 7/093**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Institut Mines Telecom**
**91120 Palaiseau (FR)**

(72) Inventor: **JABBOUR, Chadi**
**92120 ANTONY (FR)**

(74) Representative: **Cabinet Nony**
**11 rue Saint-Georges**
**75009 Paris (FR)**

(54) **SAMPLING-BASED CLOCK CALIBRATION TECHNIQUE**

(57) Method for calibrating an oscillator frequency $f_{osc}$ of an oscillator signal in an electronic system functioning at a reference clock with a frequency $f_{clock}$, comprising:

a) sampling of $f_{osc}$ at $f_{clock}$;
b) comparing the samples to a threshold value and obtaining a binary comparison signal;
c) counting the number of transitions from zero to one and/or from one to zero in the comparison signal during a number of cycles $N_{trans-calib}$ of the reference clock;
d) in case $f_{clock} \geq 2 f_{osc-id}$ where $f_{osc-id}$ is the ideal oscillator frequency, determining the real oscillator frequency:

$$f_{osc-real} = \frac{f_{osc-id} N_{trans-real}}{N_{trans-id}}$$

$N_{trans-real}$ is the counted number of transitions and $N_{trans-id}$ is the ideal number of transitions that should occur during $N_{trans-calib}$;
in case $f_{clock} < 2 * f_{osc-id}$, determining the real perceived oscillator frequency

$$f_{perceived-real} = \frac{f_{perceived-id} N_{trans-real}}{N_{trans-id}}$$

$f_{perceived-id}$ is the ideal perceived oscillator frequency

$$f_{perceived-id} = \left| f_{osc-id} - f_{clock} \cdot \left\lfloor \frac{f_{osc-id}}{f_{clock}} \right\rceil \right|$$

the $\lfloor \cdot \rceil$ represents the rounding function;

e) correcting the oscillator frequency until $N_{trans-real} = N_{trans-id}$

[Fig 10]

Fig. 10

## Description

### Technical domain

The present invention relates to a calibration method of an oscillator and its corresponding circuit.

### Prior art

The number of low power devices, sensors and nodes including Internet of Things (IoT) has increased drastically during the last decade and will probably continue increasing in the next years and decades.

Estimates in 2030, like in the publication GSMA, "Iot for development: Use cases delivering impact" in IoT white-papers, 2023, indicate around 37 billions of connected devices and numbers will continue increasing in the future.

Almost all these applications require integrated oscillators and even in some cases such as biomedical systems, RFID tags and harvesting systems, analog oscillators are used. Unfortunately, due to process, voltage and temperature (PVT) variations, the oscillation frequency can change leading to synchronization problems and other dysfunctionalities. The most common way to address this problem is the use of phase lock loops (PLL). PLL-based solutions are described for example in the papers Y.-C. Huang et al. "A 2.4-GHz Sub-harmonically Injection-Locked PLL With Self-Calibrated Injection Timing" and S. Kundu et al. "25.5 A Self-Calibrated 1.2-to-3.8GHz 0.0052mm2 Synthesized Fractional-N MDLL Using a 2b Time-Period Comparator in 22nm FinFET CMOS".

This solution is accurate and robust against slow variations. Innovations were proposed to improve its performance based on:

- the use of replica cells, like in the paper S. Choi et al. "A PVT-Robust and Low-Jitter Ring-VCO-Based Injection-Locked Clock Multiplier With a Continuous Frequency-Tracking Loop Using a Replica-Delay Cell and a Dual-Edge Phase Detector",
- voltage droop compensation, like in the paper D. Kim et al. "Adaptive Clocking Using Supply Tracking Clock Modulator With Background-Calibrated Supply Sensitivity",
- time to digital converter, like in the paper B. M. Helal et al. "A Low Jitter Programmable Clock Multiplier Based on a Pulse Injection-Locked Oscillator With a Highly-Digital Tuning Loop" or
- post-silicon hardware-in-the-loop optimization, like in the paper M. Gonzalez et al. "Post-Silicon Optimization of a Highly Programmable 64-MHz PLL Achieving 2.7-5.7 uW". All these PLL-based techniques are interesting, robust and accurate. However, they suffer from the same disadvantages of having a high complexity especially when targeting extremely low power consumption devices.

Another much simpler calibration family is the integer counting based approach, as described for instance in the patent US 8,872,548 and the publications J.-F. Huang et al. "360nW self-calibrated clock generator operating from 50° C to 120°C" and Sheafor "Method and apparatus for low jitter distributed clock calibration". It consists in establishing a listening window of a known duration and to count the oscillator cycles during this window. The oscillator is then adjusted accordingly to compensate for PVT variations (process, voltage and temperature variations). The listening window is either created using an external clock or a message preamble. Contrary to PLL-based approaches, this calibration family has a low complexity but achieving a good accuracy is difficult because it depends on the listening window time precision. Besides, the integer counting technique is sensitive to the accumulated jitter of the main clock and requires converting the signal to be calibrated into a square signal. If the oscillator signal is not square as for example in the case of an LC type analog oscillator, the oscillator output must first be converted into a square signal to be able to use the integer counting technique.

Some other solutions propose manual calibrations, like the one described in Robertson "Calibrating the 16 MHz IRC on the MPC5510" or in STMicroelectronics "How to optimize STM32 MCUs internal RC oscillator accuracy", 2018. This approach is simple and can be tweaked to optimize the performance but obviously it has the drawback of requiring a human intervention and its all-ensuing problems (time consuming, not possible for implanted, distant or dangerously placed devices).

### Disclosure of the invention

Thus, there is a need to overcome the abovementioned drawbacks of the prior art oscillator calibration techniques and improve the latter especially in terms of accuracy, simplicity and overhead.

The present invention proposes to tackle a part or all these challenges and manages to present a novel approach using the sampling theory.

Calibration method

One object of the invention, according to a first of its aspects, is a method for calibrating an oscillator frequency $f_{osc}$ of an oscillator signal in an electronic system functioning at a reference clock with a frequency $f_{clock}$, the method comprising:

a) sampling of the oscillator frequency $f_{osc}$ at the reference clock frequency $f_{clock}$;
b) comparing the samples obtained at step a) to a threshold value and obtaining a binary comparison signal;
c) counting the number of transitions from zero to one and/or from one to zero in the comparison signal during a number of cycles $N_{trans-calib}$ of the reference clock;
d) in case $f_{clock} \geq 2\, f_{osc-id}$ where $f_{osc-id}$ is the ideal oscillator frequency at which the oscillator is initialized, determining the real oscillator frequency $f_{osc-real}$ as:

$$f_{osc-real} = \frac{f_{osc-id} N_{trans-real}}{N_{trans-id}}$$

where $N_{trans-real}$ is the counted number of transitions in step c) and $N_{trans-id}$ is the ideal number of transitions that should occur during $N_{trans-calib}$;
in case $f_{clock} < 2 * f_{osc-id}$, determining the real perceived oscillator frequency $f_{perceived-real}$ as:

$$f_{perceived-real} = \frac{f_{perceived-id} N_{trans-real}}{N_{trans-id}}$$

where $f_{perceived-id}$ is the ideal perceived oscillator frequency and is given by:

$$f_{perceived-id} = \left| f_{osc-id} - f_{clock} \cdot \left\lfloor \left| \frac{f_{osc-id}}{f_{clock}} \right| \right\rceil \right|$$

where the

$$\lfloor . \rceil$$

represents the rounding function;

e) correcting the oscillator frequency until $N_{trans-real} = N_{trans-id}$,

Using an external reference (the reference clock of the electronic system), the presented solution uses the sampling theory to estimate the real oscillator frequency and to perform the correction.

Thanks to the invention, any oscillator frequency can be calibrated, whether the Nyquist theorem is respected or not.

The threshold value can be substantially equal to the average voltage of the oscillator signal, preferably being substantially equal to the circuit common mode.

"Substantially equal" is to be understood as equal with a difference of less than 10%, better still less than 5%, even better less than 1%.

In one embodiment, the oscillator is LC tank-based having a fixed part and a variable part, the fixed part comprising an inductor and a capacitor whose value is $C_{min}$ defined as the minimal capacitor value, the variable part comprising a calibration network defined by a capacitor bank that comprises branches connected in parallel, each branch comprising a capacitor connected in series with a switch, the capacitor value being $2^i \cdot C_u$, where $C_u$ is the unitary value, i an integer varying from 0 to $N_c$-1 and $N_c$ the number of bits of the capacitor bank.

The correction in step e) can be an iterative trial-and-error correction where the value of the oscillator frequency is modified step-by-step by incrementing the capacitor value by the unitary value $C_u$. This correction method has the advantage of being simple but requires repeating the calibration phase $2^{Nc-1}$ times in case of unitary increment.

Preferably, the correction in step e) consists in computing a capacitor index value $ind_{corr}$ analytically then map it into the capacitor bank, the capacitor index value being computed as follows:

$$\mathrm{ind_{corr}} = \left\lfloor \left( \left( \frac{f_{osc-real}}{f_{osc-id}} \right)^2 C_{Nom} - C_{min} \right) \frac{2^{Nc}}{C_{max} - C_{min}} \right\rceil$$

where $C_{Nom}$ is the nominal capacitor value corresponding to the ideal oscillator frequency, and $C_{max}$ is the maximal capacitor value. This correction method is efficient, especially in terms of energy consumption since it requires to run the calibration phase only once.

In one embodiment, $N_{trans\text{-}calib}$ is increased to improve the accuracy of calibration. $f_{clock}$ can be reduced by using a divided version of the reference clock, in order to improve the accuracy of calibration, as well.

Preferably, step d) is performed using an initial modified frequency $f_{calib}$ instead of $f_{osc-id}$, $f_{calib}$ being chosen such that the variation distribution of the samples is included in one Nyquist band, $f_{perceived\text{-}real}$ being computed as:

$$f_{perceived-real} = \frac{f_{perceived-id} N_{trans-real}}{N_{trans-id}} \cdot \frac{f_{perceived-id}}{f_{perceived-calib}}$$

where $f_{perceived\text{-}calib}$ is calculated as:

$$f_{perceived-calib} = \left| f_{calib} - f_{clock} \cdot \left\lfloor \frac{f_{calib}}{f_{clock}} \right\rceil \right|$$

This allows, when the distribution of the samples is spread on two Nyquist bands, to prevent the samples on the wrong Nyquist band from being corrected by the wrong terms, and therefore avoids that the correction fails.

The capacitor whose value is $C_{min}$ may comprise two parallel capacitors, these capacitors being activated or deactivated depending on the values of $f_{calib}$ and $f_{osc-id}$.

Before calibration, $C_{min}$ may be set to a value such that the oscillator frequency corresponds to the initial modified frequency $f_{calib}$.

After calibration, $C_{min}$ may be set to a value such that the oscillator frequency corresponds to the ideal oscillator frequency $f_{osc-id}$.

In case the +/- 3-σ frequency variation is higher than the reference clock $f_{clock}$, a preliminary calibration is preferably carried out to reduce the +/- 3-σ frequency variation below $f_{clock}$.

The calibration may be performed in multiple phases, a first phase using a coarse correction network and at least one further phase using a fine-tuning correction network, each correction network comprising a bank of capacitors, the first phase being performed using $f_{clock}$ and consisting in reducing the error distribution of the reference clock frequency by the resolution of the coarse correction network, the at least one further phase being performed using a divided version of the reference clock $f_{clock\_phase2}$, the frequency distribution being fit in one Nyquist band of $f_{clock-phase2}$ after the first phase. This multistep correction further improves the precision of the calibration method especially if very high resolution is needed.

Electronic circuit

Another object of the invention, according to another of its aspects, is a circuit for implementing the method according to the invention, comprising:

- an LC tank-based oscillator having a fixed part and a variable part, the fixed part comprising an inductor and a capacitor whose value is $C_{min}$ defined as the minimal capacitor value, the variable part comprising a calibration network defined by a capacitor bank that comprises branches connected in parallel, each branch comprising a capacitor connected in series with a switch, the capacitor value being $2^i \cdot C_u$, where $C_u$ is the unitary value, i an integer varying from 0 to $N_c$-1 and $N_c$ the number of bits of the capacitor bank;
- a dynamic latch-based comparator clocked at $f_{clock}$, the comparator being configured to perform the sampling and comparison operations;
- a flip-flop configured to delay the output signal of the comparator by one period of the clock;
- a XOR gate configured to compare the output signal of the comparator to its delayed version to detect the transitions;
- a digital control block comprising:

-- a digital counter configured to count the number of transitions $N_{trans-real}$,

-- a memory for storing the values of calibration parameters, such as $N_{trans-calib}$, $N_{trans-id}$, $N_c$, $f_{osc-id}$ and $f_{perceived-id}$, especially determined by calculations and simulations;

-- a computation unit configured to compute a capacitor index value $ind_{corr}$ analytically, the capacitor index value being computed as follows:

$$\text{ind}_{\text{corr}} = \left\lfloor \left( \left( \frac{f_{\text{osc-real}}}{f_{\text{osc-id}}} \right)^2 C_{\text{Nom}} - C_{\text{min}} \right) \frac{2^{\text{Nc}}}{C_{\text{max}} - C_{\text{min}}} \right\rceil$$

where $C_{Nom}$ is the nominal capacitor value corresponding to the ideal oscillator frequency, and $C_{max}$ is the maximal capacitor value; and

-- a control unit configured to monitor the switches of the calibration network by mapping the capacitor index value into the capacitor bank.

Another object of the invention, according to another of its aspects, is a computer program product containing instructions readable by the processor of an apparatus, for managing the digital control block of the circuit according to the invention, especially performing the calculations and the simulations needed to obtain the calibration parameters stored in the memory, and for managing the computation unit.

## Brief description of the figures

The invention will be better understood on reading the following detailed description of non-limiting exemplary embodiments thereof and on examining the appended drawings in which:

- Figure 1 schematically illustrates the general principle of the proposed calibration method through three examples of sampling curves and corresponding output comparison signals at different oscillator frequencies;
- Figure 2 represents two examples of Monte Carlo simulations before and after calibration at different oscillator frequencies;
- Figure 3 depicts a schematic of an example of an oscillator with its calibration network;
- Figure 4, similar to Figure 1, schematically illustrates three other examples of sampling curves and corresponding output comparison signals at different oscillator frequencies;
- Figure 5, similar to Figure 2, represents examples of Monte Carlo simulations before and after calibration when varying the calibration window;
- Figure 6, similar to Figure 5, represents examples of Monte Carlo simulations before and after calibration when varying the clock frequency;
- Figure 7 represents examples of Monte Carlo simulations before and after calibration when varying the 3-$\sigma$ frequency;
- Figure 8 represents examples of Monte Carlo simulations before and after calibration when modifying the oscillator frequency;
- Figure 9 illustrates examples of Monte Carlo simulations for multi-phase calibration;
- Figure 10 represents a schematic of an example of an electrical circuit implementing the proposed calibration method; and
- Figure 11 shows example curves of the RMS and maximum error after calibration as a function of comparator offset and clock jitter.

## Detailed description of the figures

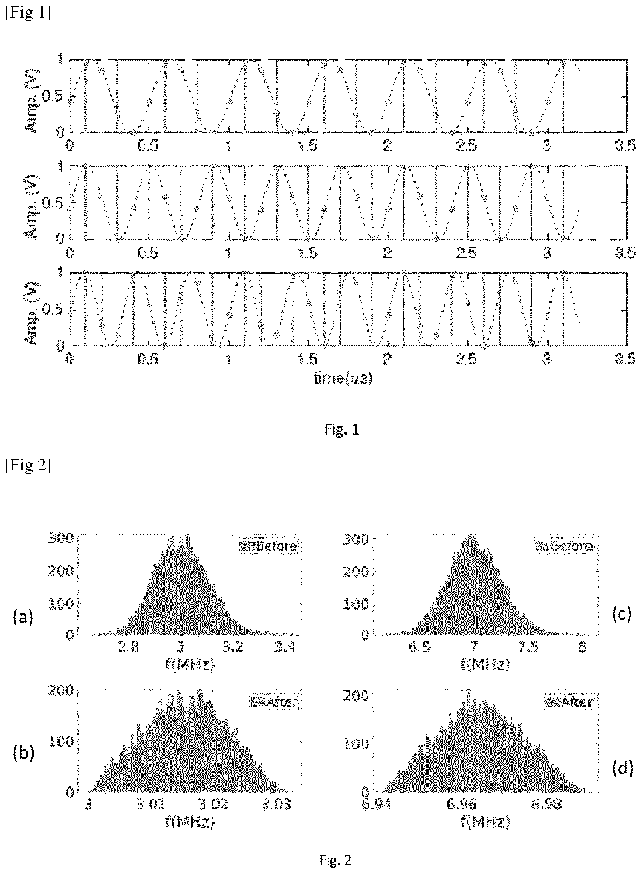

The general operation of the calibration method according to the invention is based on performing a sampling of the oscillator signal at the reference clock signal followed by a 1-bit comparison and to count the number of transitions (transitions 0 to 1 and vice versa) during a given time window or a number of cycles of the reference clock. As it will be shown later, this operation is very simple and can be realized by a simple dynamic comparator and simple digital operations. Figure 1 shows an example for 3 values of oscillator frequencies $f_{osc-id}$: 2 MHz, 2.5 MHz and 3 MHz. The clock frequency $f_{clock}$ is set to 10 MHz and the calibration window size $N_{calib}$ is set to 32, which results in a listening window of 32 µs. As can be seen, the number of transitions is respectively 13, 16 and 19 for the 3 values of $f_{osc-id}$.

The method according to the invention uses this metric for the oscillator frequency estimation. Let $f_{osc-id}$ be the ideal or nominal oscillator frequency and $f_{osc-real}$ the real oscillator frequency whose value was modified due to PVT variations. The number of transitions that should occur during the $N_{calib}$ window is given by:

[Equation 1]

$$N_{trans-id} = \left\lfloor \frac{2f_{osc-id}N_{calib}}{f_{clock}} \right\rfloor,$$

Where the

$$\lfloor . \rfloor$$

represents the rounding function. The obtained number of transitions in practice can be calculated similarly:

[Equation 2]

$$N_{trans-real} = \left\lfloor \frac{2f_{osc-real}N_{calib}}{f_{clock}} \right\rfloor,$$

Thus, the real oscillator frequency can be determined as follows:

[Equation 3]

$$f_{osc-real} = \frac{f_{osc-id}N_{trans-real}}{N_{trans-id}}.$$

The correction can be then performed iteratively or numerically by adjusting the oscillator components to make $N_{trans\_real}$ equal to $N_{trans-id}$.

The correction, that will be discussed in detail further, may be performed using a capacitor bank.

Figure 2 shows two Montecarlo simulations with 10000 samples, $f_{clock} = 10$ MHz and $N_{calib} = 256$. The considered oscillator is LC tank based. Two oscillation frequencies are considered with 3 MHz (lefthand figures 2(a) and 2(b)) and 7 MHz (righthand figures 2(c) and 2(d)). The 3-sigma variations for the inductors and capacitors are uncorrelated and both set to 15%. This results in a 3-sigma variation for the oscillator frequency of 11.1%. The sinewave phase is also random. The correction precision is 7 bits. As can be noted in Figure 2, the error after calibration is almost equal to the capacitor bank precision with less than 1% of error (topmost figures (a) and (c) representing simulations before calibration and bottommost figures (b) and (d) representing simulations after calibration).

It is worth noting that for the 7 MHz case, $f_{clock} < 2 * f_{osc-id}$ and consequently, the system does not respect the Shannon-Nyquist theorem. Nevertheless, as can be seen from Figure 2, the calibration works perfectly. Actually, the oscillator frequency folds in this case in the first Nyquist Band.

The perceived frequency by the system is given by:

[Equation 4]

$$f_{perceived-id} = \left| \left( f_{osc-id} - f_{clock} \cdot \overbrace{\underbrace{\left\lfloor \frac{f_{osc-id}}{f_{clock}} \right\rceil}_{ratioNB}}^{signNB} \right) \right|$$

where ratioNB corresponds to the Nyquist band of $f_{osc-id}$ and signNB is the sign of the Nyquist Band. For example, ratioNB = 2 for $1.5f_{clock} < f_{osc-id} < 2.5f_{clock}$. Using the same example (ratioNB = 2), signNB = -1 for $1.5f_{clock} < f_{osc-id} < 2f_{clock}$ and signNB = 1 for $2f_{clock} < f_{osc-id} < 2.5f_{clock}$.

In the folding case, the calculations detailed in equations 1 to 3 should be adjusted by replacing $f_{osc-id}$ by $f_{perceived-}$

*id* and $f_{osc\text{-}real}$ by $f_{perceived\text{-}real}$.

The perceived frequency in the 7 MHz case is actually 3 MHz and as a consequence, the perceived frequency and the ideal number of transitions is the same for the two simulations.

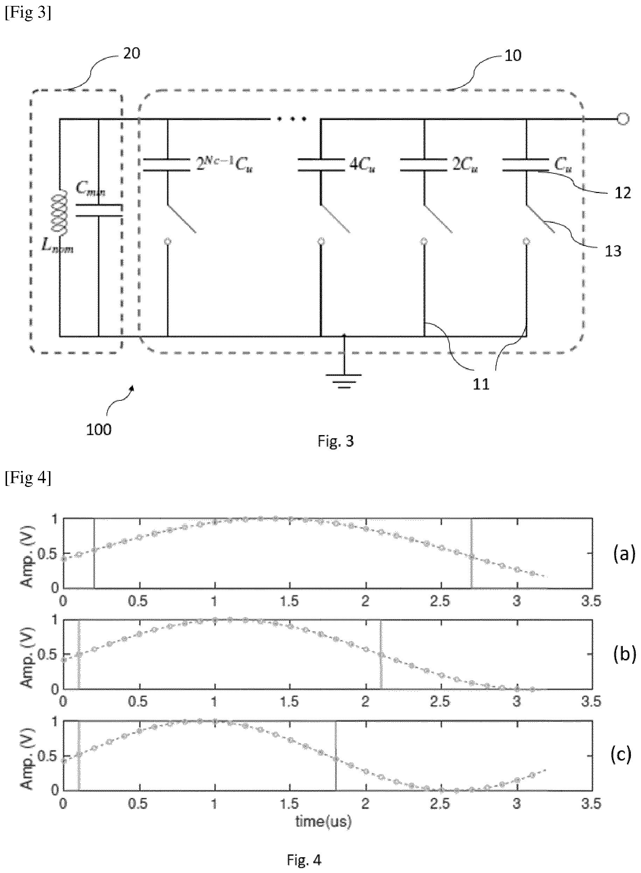

Figure 3 depicts a schematic of an example of an oscillator 100 with its calibration network. The oscillator 100 is LC tank-based having a fixed part 20 and a variable part 10. The fixed part 20 comprises an inductor whose value is $L_{nom}$ and a capacitor whose value is $C_{min}$ defined as the minimal capacitor value. The variable part 10 comprises a calibration network defined by a capacitor bank that comprises branches 11 connected in parallel. Each branch 11 comprises a capacitor 12 connected in series with a switch 13, the capacitor value being $2^i \cdot C_u$, where $C_u$ is the unitary value, i an integer varying from 0 to $N_c$-1 and $N_c$ the number of bits of the capacitor bank.

In the example of Figure 2, the simulations were carried out with an iterative trial-and-error correction. In other terms, the value of the oscillating frequency was modified step-by-step by incrementing the capacitor value of the oscillator 100 by a unitary value and once $N_{trans\text{-}real} = N_{trans\text{-}id}$, the calibration is stopped. This correction approach is simple but far from being optimal in terms of latency and energy consumption, because it requires repeating the calibration phase $2^{Nc\text{-}1}$ times in case of a unitary increment. The number of calibration phases can be reduced by using other approaches such as dichotomy, but it will still require repeating the calibration phase many times.

A more efficient approach is to compute the capacitor index value analytically, which requires running the calibration phase only once. To explain the procedure more clearly, let us consider the LC tank-based resonator. Its oscillation frequency is given by:

[Equation 5]

$$f_{osc\text{-}id} = \frac{1}{2\pi\sqrt{L_{Nom}C_{Nom}}}$$

To perform the calibration, a simple capacitor bank as the one shown in Figure 3 can be used. As explained above, the network is decomposed into a fixed part 20 and a variable part 10 which would change the capacitor value from $C_{min}$ to $C_{max}$. The values of $C_{min}$ and $C_{max}$ are fixed depending on the expected 3-sigma variation of the LC tank. The unitary capacitance $C_u$ is simply:

[Equation 6]

$$C_u = \frac{C_{max} - C_{min}}{2^{Nc}}$$

Using equations 1, 2 and 4, the value of the real oscillation frequency after aliasing if there is any, $f_{perceived\text{-}real}$, could be computed as:

[Equation 7]

$$f_{perceived\text{-}real} = \frac{f_{perceived\text{-}id}N_{trans\text{-}real}}{N_{trans\text{-}id}}$$

By adapting equation 4 to the $f_{perceived\text{-}real}$ case and injecting it in equation 7, the value $f_{osc\text{-}real}$ could be calculated:

[Equation 8]

$$f_{osc\text{-}real} = signNB \cdot f_{perceived\text{-}real} + ratioNB \cdot f_{clock}$$

Using equations 8 and 5, the needed value for the capacitor $C_{corr}$ is calculated as:

[Equation 9]

$$C_{corr} = \left(\frac{f_{osc-real}}{f_{osc-id}}\right)^2 C_{Nom}$$

The value of $C_{corr}$ is then mapped into the discrete capacitor bank. The index value for the correction is simply:

[Equation 10]

$$ind_{corr} = \left\lfloor \left(\left(\frac{f_{osc-real}}{f_{osc-id}}\right)^2 C_{Nom} - C_{min}\right)\frac{2^{Nc}}{C_{max} - C_{min}}\right\rfloor.$$

The precision of the proposed calibration method is fixed by two aspects. The first is, as in any calibration system, the precision of the correction system, i.e. the capacitor bank in the example given above. The second aspect that can limit the calibration precision is the number of transitions. The number of transitions is integers, therefore there is a range of frequency that can match the number of transitions. Also, the phase difference between the oscillator and calibration clocks can increase/reduce $N_{trans-real}$ by 1.

Figure 4 shows a simulation for 3 values of $f_{osc-id}$ : 0.2 MHz in Figure 4(a); 0.25 MHz in Figure 4(b) and 0.3 MHz in Figure 4(c). $N_{calib}$ = 32 and $f_{clock}$ = 10 MHz. In each Figure 4, the dashed line represents the oscillator output, the circles on the line the samples and solid line the comparator output. As can be seen, since the oversampling ratio is extremely high for the 3 cases, the number of transitions is 2 for all of them and therefore it is impossible to distinguish the 3 signals. To overcome this problem, the number of transitions $N_{trans-id}$ should be increased. Rewriting equation 1 with the general expression:

[Equation 11]

$$N_{trans-id} = \left\lfloor \frac{2f_{perceived-id}N_{calib}}{f_{clock}}\right\rfloor.$$

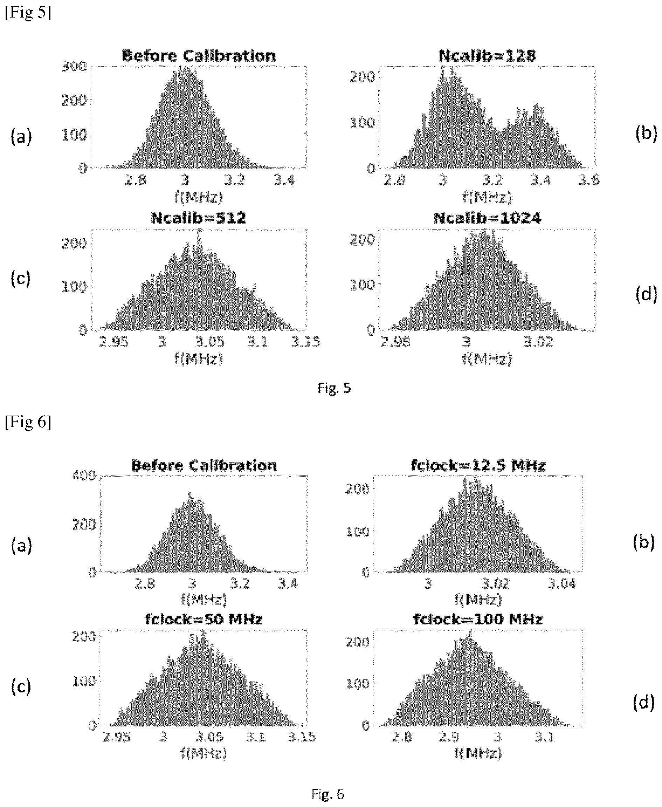

Based on equation 11, one can identify two ways to increase $N_{trans-id}$: i) increase $N_{calib}$ which can be done easily by extending the comparison window but is paid in a higher latency, complexity (counter size) and energy consumption ii) increase $f_{perceived-id}/f_{clock}$ which can be achieved by reducing $f_{clock}$ by using a divided version of the clock instead of using the original value. For example, in the example of Figure 4, if $f_{clock}$ is divided by 10 which can be very easily done, the results will be equivalent to the results of Figure 1 with 13, 16 and 19 transitions respectively for the 0.2, 0.25 and 0.3 MHz oscillation frequencies. To illustrate $N_{calib}$ impact on the performance, simulations were carried out for $f_{osc-id}$ of 3 MHz and $f_{clock}$ of 100 MHz. Montecarlo simulations with 10000 points are depicted in Figure 5, showing the distribution before calibration (Figure 5(a)), with $N_{calib}$ = 128, (Figure 5(b)), $N_{calib}$ = 512 (Figure 5(c)) and $N_{calib}$ = 1024 (Figure 5(d)). As can be seen from Figure 5, for an $N_{calib}$ of 128 which gives an $N_{trans-id}$ of only 8, the precision is low and in some cases the algorithm diverges. When $N_{calib}$ is increased to 512, the precision is increased, and the 3-sigma variation is around $\pm$120 kHz. Increasing $N_{calib}$ reduces it by a factor to $\pm$30 kHz.

A similar analysis was also performed to analyze the impact of $f_{perceived-id}/f_{clock}$. $f_{osc-id}$ is kept equal to 3 MHz, and $N_{calib}$ = 256. Montecarlo simulations with 10000 points are depicted in Figure 6, showing the distribution before calibration (Figure 6(a)), with $f_{clock}$ = 12.5 MHz, (Figure 6(b)), $f_{clock}$ = 50 MHz (Figure 5(c)) and $f_{clock}$ = 100 MHz (Figure 5(d)). In other terms, three versions of $f_{clock}$ are considered, the nominal value at 100 MHz, a divided by 2 version at 50 MHz and a divided by 8 version at 12.5 MHz. As can be noted from Figure 6, reducing $f_{clock}$ improves the precision as it increases $N_{trans-id}$ (15 for 100 MHz, 31 for 50 MHz and 123 for 12.5 MHz).

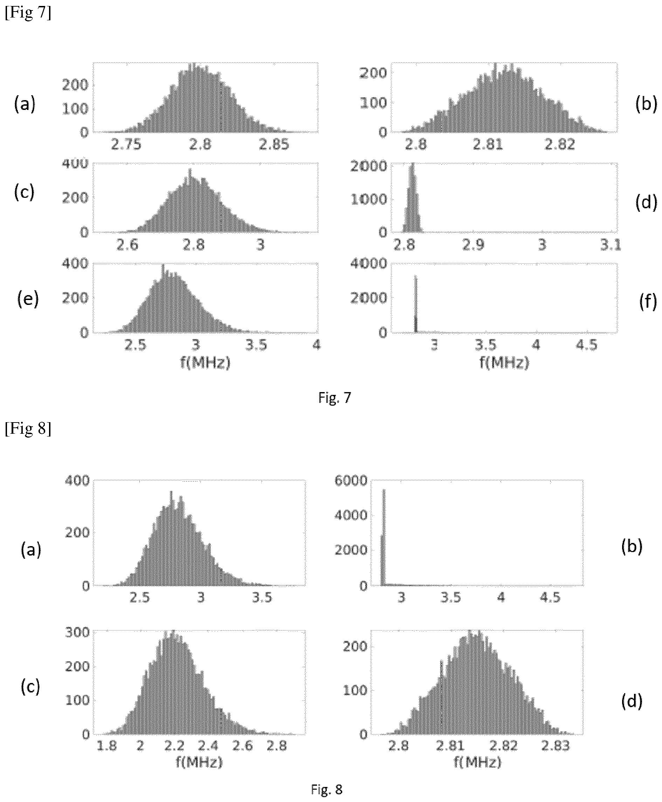

As explained earlier, the proposed approach is operational even when $f_{clock}$ < 2 * $f_{osc-id}$. However, adapting the approach required to adjust the calculation in equation 8 to the Nyquist band of the $f_{osc-real}$ distribution. However, when the distribution is spread on two Nyquist bands, the samples on the wrong Nyquist band are corrected by the wrong terms and therefore the correction will fail. To illustrate more clearly this concept, Montecarlo simulations were realized with 10000 samples and $N_{calib}$ = 256. The results are depicted in Figure 7, where the lefthand figures (Figures 7(a), 7(c) and 7(e)) represent the simulations before calibration and the righthand figures (Figures 7(b), 7(d) and 7(f)) represent the simulations after calibration. $f_{clock}$ is set to 6 MHz and $f_{osc-id}$ to 2.8 MHz, which is at 200 kHz offset (7% of $f_{osc-id}$) of the first Nyquist Band limit at $f_{clock}$/2, i.e., 3 MHz. Three cases are considered with respectively 3-sigma variations of 2%

**EP 4 564 682 A1**

(Figures 7(a) and 7(b)), 8 % (Figures 7(c) and 7(d)) and 22% (Figures 7(e) and 7(f)).

In the 2% case, the whole distribution is lower than 3 MHz and as can be seen from Figure 7(b), the correction works perfectly. In the 8% case, 0.085% of the samples have values higher than 3 MHz and for almost the same percentage of the samples (0.072%) the correction diverges. For the 22% case, 17.8% of the samples are higher than 3 MHz and as expected, for a very similar percentage (17.2%) of the samples, the correction converges to a wrong value.

To overcome this problem, a modification of the algorithm can be introduced. It consists in performing the variation measurement using a frequency $f_{calib}$ different from $f_{osc-id}$. $f_{calib}$ is chosen in a way that the distribution is included in one Nyquist band. For example, in the simulations of Figure 7 with the 22% 3-sigma variation, a frequency $f_{calib}$ of 2.2 MHz is chosen to guarantee that the whole distribution is in the first Nyquist band. The oscillator is initialized with the frequency $f_{calib}$, the rest of the algorithm is run normally with just a modification in equation 7 which is multiplied by a factor $f_{perceived-id}/f_{perceived-calib}$. $f_{perceived-calib}$ is calculated in the same way from $f_{calib}$ using equation 4.

Figure 8 illustrates examples of Monte Carlo simulations with 10000 samples and $N_{calib} = 256$, where the lefthand figures (Figures 8(a) and 8(c)) represent the simulations before calibration and the righthand figures (Figures 8(b) and 8(d)) represent the simulations after calibration. Figures 8(a) and 8(b) correspond to the approach without modification of the oscillator frequency and figures 8(c) and 8(d) correspond to the approach with the modification of the oscillator frequency (referred to hereafter as modified approach).

As can be noted in Figure 8, using the modified approach, the calibration is again perfectly functional. The overhead for the modification is very small, it just requires building $C_{min}$ using two parallel capacitors activated/deactivated depending on the values of $f_{osc-id}$ and $f_{calib}$.

It is worth noting that even with the proposed modification, the algorithm can diverge if the frequency variation is higher than $f_{clock}$. As a matter of fact, in this case, it is impossible to have the distribution in only one Nyquist Band and therefore the algorithm can converge to the wanted frequency or to one of its images. Nevertheless, this limitation is not very constraining as it requires special conditions on $f_{clock}$, $f_{osc-id}$ and its 3-sigma variation. Moreover, this limitation can be addressed by using a first coarse calibration such as integer counting to reduce the variation below $f_{clock}$ and then using the proposed technique to fine tune the oscillator.

To further improve the precision of the proposed algorithm if very high resolution is needed, it is possible to perform the correction in multi-phases. For the sake of simplicity, it will be detailed for two phases, but it can be extended to a higher number of phases. The operation is based on having two correction networks, the first for the coarse correction and the second for the fine tuning.

The first phase calibration is performed using the nominal $f_{clock}$. The first correction will reduce error distribution of the reference clock frequency by the resolution of the coarse correction network (if $N_{trans-id}$ is high enough). This would allow to start a second phase with a significantly slower clock, $f_{clock-phase2}$ as it will be possible to fit the distribution in one Nyquist Band of the $f_{clock-phase2}$

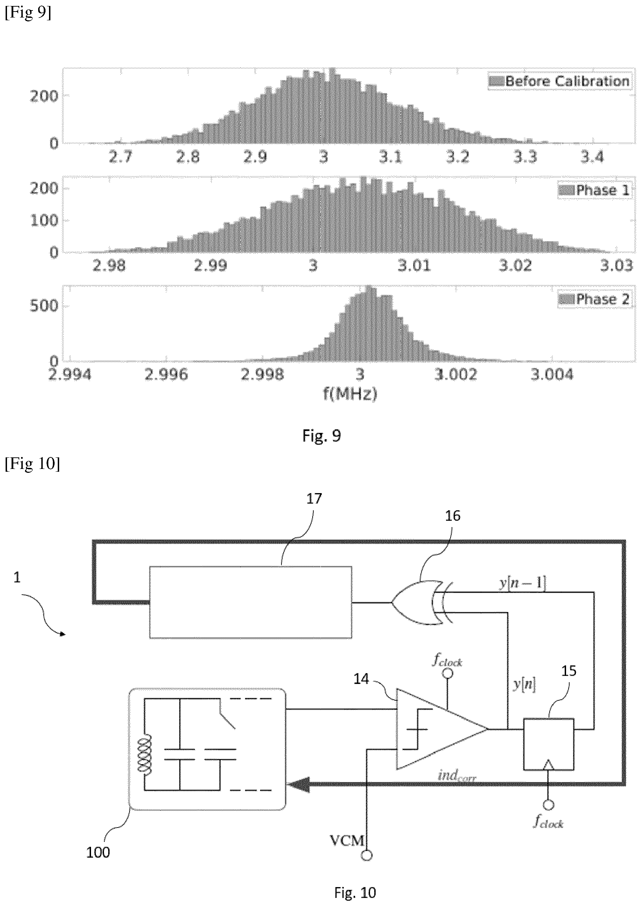

Figure 9 shows a 2-phase simulation with $f_{osc-id} = 3$ MHz, $f_{clock} = 10$ MHz and $f_{clock-phase2} = f_{clock}/31$. It is a Montecarlo simulation with 10000 samples and $N_{calib} = 256$ for each phase. The resolution of each network is 6 bits. The simulation shows improvement after each phase. The final 3-sigma variation is 2.4 kHz or 0.08% of $f_{clock}$. It is worth noting that achieving the same resolution with a single-phase system requires a 12-bit network and an $N_{calib}$ of 4096.

Figure 10 represents a schematic of an example of an electrical circuit 1 implementing the proposed calibration method. The circuit 1 comprises an LC tank-based oscillator 100, a dynamic latch-based comparator 14 clocked at $f_{clock}$, a flip-flop 15, a XOR gate 16 and a digital control block 17.

The comparator 14 is configured to perform the sampling and comparison operations. The flip-flop 15 is configured to delay the output signal y[n] of the comparator 14 by one period of the clock. The XOR gate 16 is configured to compare the output signal y[n] of the comparator 14 to its delayed version y[n-1] to detect the transitions. The digital control block 17 comprises :

-- a digital counter configured to count the number of transitions $N_{trans-real}$,
-- a memory for storing the values of calibration parameters, such as $N_{trans-calib}$, $N_{trans-id}$, $N_c$, $f_{osc-id}$ and $f_{perceived-id}$, especially determined by calculations and simulations;
-- a computation unit configured to compute a capacitor index value $ind_{corr}$ analytically, the capacitor index value being computed as follows:

$$\text{ind}_{corr} = \left\lfloor \left( \left( \frac{f_{osc-real}}{f_{osc-id}} \right)^2 C_{Nom} - C_{min} \right) \frac{2^{Nc}}{C_{max} - C_{min}} \right\rceil$$

where $C_{Nom}$ is the nominal capacitor value corresponding to the ideal oscillator frequency, and $C_{max}$ is the maximal capacitor value; and

9

-- a control unit configured to monitor the switches of the calibration network by mapping the capacitor index value into the capacitor bank.

For a given scenario ($f_{clock}$, $f_{osc-id}$, required precision, ...), the values of the calibration parameters ($f_{perceived-id}$, $N_{calib}$, signNB, ratioNB, $C_{min}$, $C_{max}$, $N_c$, ...) are determined by calculations and system simulations. They are then stored in the calibration digital control block.

At the beginning of the calibration, all counters are set to zero and the oscillator is configured to oscillate at its nominal value. The oscillator output is applied to the dynamic latch-based comparator 14. The comparator output y[n] is applied to the flip-flop 15 which delays the signal by one period, then the XOR gate compares the output y[n] to its delayed version y[n-1] to detect the transitions. It is then sufficient to count the number of transitions using the digital counter to obtain $N_{trans-real}$. Using equation 7, $f_{perceived-real}$ could be computed and plugging it into equation 10, the capacitor bank index $ind_{corr}$ could be calculated. As can be noticed, the system is very simple. It requires only a simple dynamic latch and basic digital circuitry.

The system simulations assumed a perfect circuitry (except obviously the process variation). To study the impact of circuit non-idealities on the calibration performance, a wide variety of system simulations were carried out modelling errors such as comparator non-idealities (offset and hysteresis), $f_{clock}$ jitter and capacitor mismatch.

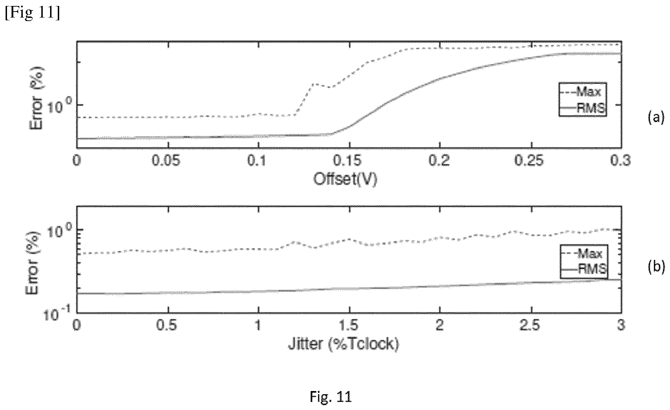

Figure 11 shows example curves of the RMS and maximum error after calibration as a function of comparator offset and clock jitter.

For the sake of simplicity, only 2 simulations are presented. The simulation conditions are based on the targeted application with an $f_{clock}$ of 5.6 MHz and an $f_{osc-id}$ of 4 MHz. The oscillation signal has a common mode VCM of 0.5 V and an amplitude of 0.3 V. The calibration network has a 7-bit resolution, $N_{calib}$ is 256 and a 3-sigma variation of 11.1% on $f_{osc-id}$ before calibration. Figure 11(a) shows the RMS and maximum error after calibration as a function of comparator offset. Each simulation point of the curve is a 10000-point Montecarlo analysis. As can be seen, the calibration exhibits a very good robustness up to 0.11 V of offset which corresponds to almost one third of the input amplitude. This good robustness reduces the matching constraints on the comparator input pair and thus enables the use of smaller transistors and consequently lower power consumption.

Figure 11(b) analyzes the impact of $f_{clock}$ phase noise or jitter on the calibration performance. The phase noise is modelled as a first order cumulative jitter and is expressed as a percentage of $T_{clock}$. The other simulation conditions are the same as the offset study. As can be noted, the calibration is very robust against $f_{clock}$ phase noise. This robustness is due to the fact that the noise does not have an impact unless it changes the sampling instant in a way that the comparator output sign changes which occurs quite rarely for common jitter values. The other studied non-idealities showed also a very good robustness of the proposed technique.

The invention is not limited to the examples that have just been described. In particular, features from the embodiments illustrated may be combined within embodiments that are not illustrated.

The invention can be applied to a leadless multi-chamber pacemaker. The application requires two implanted capsules to pace in a coordinated manner in different locations of the heart. The capsule is composed of a communication module and a pacing electrode. The communication module uses a Human Body Communication (HBC) standard for the connection between the 2 nodes based on a super regenerative receiver centered at 4 MHz. The pacing electrode is responsible of the pacing, it integrates a small micro-controller with a robust clock at 5.6 MHz. The proposed calibration has been first developed for this scenario, i.e., calibrating a 4 MHz oscillator using a 5.6 MHz clock. As described above, the present application generalizes the approach to any couple of oscillator and clock frequencies.

The expression "comprising a" or "including a" must be understood as being synonymous with "comprising at least one" or "including at least one", unless specified otherwise.

**Claims**

1. Method for calibrating an oscillator frequency $f_{osc}$ of an oscillator signal in an electronic system functioning at a reference clock with a frequency $f_{clock}$, the method comprising:

   a) sampling of the oscillator frequency $f_{osc}$ at the reference clock frequency $f_{clock}$;
   b) comparing the samples obtained at step a) to a threshold value and obtaining a binary comparison signal;
   c) counting the number of transitions from zero to one and/or from one to zero in the comparison signal during a number of cycles $N_{trans-calib}$ of the reference clock;
   d) in case $f_{clock} \geq 2 f_{osc-id}$ where $f_{osc-id}$ is the ideal oscillator frequency at which the oscillator is initialized, determining the real oscillator frequency $f_{osc-real}$ as:

$$f_{osc-real} = \frac{f_{osc-id} N_{trans-real}}{N_{trans-id}}$$

where $N_{trans-real}$ is the counted number of transitions in step c) and $N_{trans-id}$ is the ideal number of transitions that should occur during $N_{trans-calib}$;

in case $f_{clock} < 2 * f_{osc-id}$, determining the real perceived oscillator frequency $f_{perceived-real}$ as:

$$f_{perceived-real} = \frac{f_{perceived-id} N_{trans-real}}{N_{trans-id}}$$

where $f_{perceived-id}$ is the ideal perceived oscillator frequency and is given by:

$$f_{perceived-id} = \left| f_{osc-id} - f_{clock} \cdot \left\lfloor \frac{f_{osc-id}}{f_{clock}} \right\rceil \right|$$

where the

$$\lfloor \cdot \rceil$$

represents the rounding function;

e) correcting the oscillator frequency until $N_{trans-real} = N_{trans-id}$,

2. Method according to claim 1, the threshold value being substantially equal to the average voltage of the oscillator signal, preferably being substantially equal to the circuit common mode.

3. Method according to claim 1 or 2, wherein the oscillator (100) is LC tank-based having a fixed part (20) and a variable part (10), the fixed part (20) comprising an inductor and a capacitor whose value is $C_{min}$ defined as the minimal capacitor value, the variable part (10) comprising a calibration network defined by a capacitor bank that comprises branches (11) connected in parallel, each branch (11) comprising a capacitor (12) connected in series with a switch (13), the capacitor value being $2^i$. $C_U$, where $C_U$ is the unitary value, i an integer varying from 0 to $N_c$-1 and $N_c$ the number of bits of the capacitor bank.

4. Method according to claim 3, the correction in step e) being an iterative trial-and-error correction where the value of the oscillator frequency is modified step-by-step by incrementing the capacitor value by the unitary value $C_U$.

5. Method according to claim 3, the correction in step e) consisting in computing a capacitor index value $ind_{corr}$ analytically then map it into the capacitor bank, the capacitor index value being computed as follows:

$$ind_{corr} = \left\lfloor \left( \left( \frac{f_{osc-real}}{f_{osc-id}} \right)^2 C_{Nom} - C_{min} \right) \frac{2^{Nc}}{C_{max} - C_{min}} \right\rceil$$

where $C_{Nom}$ is the nominal capacitor value corresponding to the ideal oscillator frequency, and $C_{max}$ is the maximal capacitor value.

6. Method according to any one of the preceding claims, wherein $N_{trans-calib}$ is increased.

7. Method according to any one of the preceding claims, wherein $f_{clock}$ is reduced by using a divided version of the reference clock.

8. Method according to any one of the preceding claims, wherein step d) is performed using an initial modified frequency $f_{calib}$ instead of $f_{osc-id}$, $f_{calib}$ being chosen such that the variation distribution of the samples is included in one Nyquist band, $f_{perceived-real}$ being computed as:

$$f_{perceived-real} = \frac{f_{perceived-id} N_{trans-real}}{N_{trans-id}} \cdot \frac{f_{perceived-id}}{f_{perceived-calib}}$$

where $f_{perceived-calib}$ is calculated as:

$$f_{perceived-calib} = \left| f_{calib} - f_{clock} \cdot \left| \frac{f_{calib}}{f_{clock}} \right| \right|$$

9. Method according to claim 8 with a reference to claim 3, wherein the capacitor whose value is $C_{min}$ comprises two parallel capacitors, these capacitors being activated or deactivated depending on the values of $f_{calib}$ and $f_{osc-id}$.

10. Method according to claim 9, wherein before calibration, $C_{min}$ is set to a value such that the oscillator frequency corresponds to the initial modified frequency $f_{calib}$.

11. Method according to claim 10, wherein after calibration, $C_{min}$ is set to a value such that the oscillator frequency corresponds to the ideal oscillator frequency $f_{osc-id}$.

12. Method according to any one of claims 8 to 11, wherein in case the +/- 3-$\sigma$ frequency variation is higher than the reference clock $f_{clock}$, a preliminary calibration is carried out to reduce the +/- 3-$\sigma$ frequency variation below $f_{clock}$.

13. Method according to any one of the preceding claims, wherein the calibration is performed in multiple phases, a first phase using a coarse correction network and at least one further phase using a fine-tuning correction network, each correction network comprising a bank of capacitors, the first phase being performed using $f_{clock}$ and consisting in reducing the error distribution of the reference clock frequency by the resolution of the coarse correction network, the at least one further phase being performed using a divided version of the reference clock $f_{clock-phase2}$, the frequency distribution being fit in one Nyquist band of $f_{clock-phase2}$ after the first phase.

14. Circuit (1) for implementing the method according to any one of the preceding claims, comprising:

- an LC tank-based oscillator (10) having a fixed part (20) and a variable part (10), the fixed part (20) comprising an inductor and a capacitor whose value is $C_{min}$ defined as the minimal capacitor value, the variable part (10) comprising a calibration network defined by a capacitor bank that comprises branches (11) connected in parallel, each branch (11) comprising a capacitor (12) connected in series with a switch (13), the capacitor value being $2^i$. $C_u$, where $C_u$ is the unitary value, i an integer varying from 0 to $N_c$-1 and $N_c$ the number of bits of the capacitor bank;
- a dynamic latch-based comparator (14) clocked at $f_{clock}$, the comparator (14) being configured to perform the sampling and comparison operations;
- a flip-flop (15) configured to delay the output signal (y[n]) of the comparator (14) by one period of the clock;
- a XOR gate (16) configured to compare the output signal (y[n]) of the comparator (14) to its delayed version (y[n-1]) to detect the transitions;
- a digital control block comprising:

-- a digital counter configured to count the number of transitions $N_{trans-real}$,
-- a memory for storing the values of calibration parameters, such as $N_{trans-calib}$, $N_{trans-id}$, $N_c$, $f_{osc-id}$ and $f_{perceived-id}$, especially determined by calculations and simulations;
-- a computation unit configured to compute a capacitor index value $ind_{corr}$ analytically, the capacitor index value being computed as follows:

$$\text{ind}_{corr} = \left| \left( \left( \frac{f_{osc-real}}{f_{osc-id}} \right)^2 C_{Nom} - C_{min} \right) \frac{2^{Nc}}{C_{max} - C_{min}} \right|$$

where $C_{Nom}$ is the nominal capacitor value corresponding to the ideal oscillator frequency, and $C_{max}$ is the maximal capacitor value; and
-- a control unit configured to monitor the switches of the calibration network by mapping the capacitor index value into the capacitor bank.

15. Computer program product containing instructions readable by the processor of an apparatus, for managing the digital control block (17) of the circuit (1) according to claim 14, especially performing the calculations and the simulations needed to obtain the calibration parameters stored in the memory, and for managing the computation unit.

[Fig 1]

Fig. 1

[Fig 2]

Fig. 2

[Fig 3]

Fig. 3

[Fig 4]

Fig. 4

[Fig 5]

Fig. 5

[Fig 6]

Fig. 6

[Fig 7]

Fig. 7

[Fig 8]

Fig. 8

[Fig 9]

Fig. 9

[Fig 10]

Fig. 10

[Fig 11]

Fig. 11

Europäisches
Patentamt
European
Patent Office
Office européen
des brevets

# EUROPEAN SEARCH REPORT

**Application Number**

EP 23 30 7070

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/028106 A1 (ANNEMA ANNE-JOHAN [NL] ET AL) 24 January 2019 (2019-01-24) | 15 | INV.<br>H03L7/091 |
| A | * paragraph [0017] - paragraph [0022]; figure 1 *<br>* paragraph [0023] - paragraph [0026]; figure 2 *<br>* paragraph [0027] - paragraph [0030]; figure 3 *<br>* paragraph [0031] - paragraph [0035]; figure 4 * | 1-14 | H03L7/093<br>H03L7/099 |
| A | WANG JIACHENG ET AL: "A 13.8-MHz RC oscillator with self-calibration for 0.4% temperature stability from -55 to 125°C", 2015 IEEE INTERNATIONAL CONFERENCE ON ELECTRON DEVICES AND SOLID-STATE CIRCUITS (EDSSC), IEEE, 1 June 2015 (2015-06-01), pages 423-426, XP033219285, DOI: 10.1109/EDSSC.2015.7285141 ISBN: 978-1-4799-8362-9 [retrieved on 2015-09-30] *subsections: II.B. Proposed Oscillator Architecture, II.C. Main Oscillator Circuit*; figure 2 | 1-15 | |
| A | US 2009/167389 A1 (REIS RICARDO DOS SANTOS [PT]) 2 July 2009 (2009-07-02) * paragraph [0021] - paragraph [0028]; figure 2 * | 1-15 | |

**TECHNICAL FIELDS SEARCHED (IPC)**

H03L

The present search report has been drawn up for all claims

| Place of search | Date of completion of the search | Examiner |
|---|---|---|
| The Hague | 22 May 2024 | Aouichi, Mohamed |

EPO FORM 1503 03.82 (P04C01)

## ANNEX TO THE EUROPEAN SEARCH REPORT
## ON EUROPEAN PATENT APPLICATION NO.

EP 23 30 7070

This annex lists the patent family members relating to the patent documents cited in the above-mentioned European search report.
The members are as contained in the European Patent Office EDP file on
The European Patent Office is in no way liable for these particulars which are merely given for the purpose of information.

22-05-2024

| Patent document cited in search report | Publication date | Patent family member(s) | Publication date |
|---|---|---|---|
| US 2019028106 A1 | 24-01-2019 | CN 109302181 A<br>EP 3435549 A1<br>US 2019028106 A1 | 01-02-2019<br>30-01-2019<br>24-01-2019 |
| US 2009167389 A1 | 02-07-2009 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8872548 B

**Non-patent literature cited in the description**

- **Y.-C. HUANG et al.** *A 2.4-GHz Sub-harmonically Injection-Locked PLL With Self-Calibrated Injection Timing*
- **S. KUNDU et al.** *25.5 A Self-Calibrated 1.2-to-3.8GHz 0.0052mm2 Synthesized Fractional-N MDLL Using a 2b Time-Period Comparator in 22nm FinFET CMOS*
- **S. CHOI et al.** *A PVT-Robust and Low-Jitter Ring-VCO-Based Injection-Locked Clock Multiplier With a Continuous Frequency-Tracking Loop Using a Replica-Delay Cell and a Dual-Edge Phase Detector*
- **D. KIM et al.** *Adaptive Clocking Using Supply Tracking Clock Modulator With Background-Calibrated Supply Sensitivity*
- **B. M. HELAL et al.** *A Low Jitter Programmable Clock Multiplier Based on a Pulse Injection-Locked Oscillator With a Highly-Digital Tuning Loop*
- **M. GONZALEZ et al.** *Post-Silicon Optimization of a Highly Programmable 64-MHz PLL Achieving 2.7-5.7 uW*
- **J.-F. HUANG et al.** *360nW self-calibrated clock generator operating from 50° C to 120°C*
- **SHEAFOR**. *Method and apparatus for low jitter distributed clock calibration*
- **ROBERTSON**. *Calibrating the 16 MHz IRC on the MPC5510*
- **STMICROELECTRONICS**. *How to optimize STM32 MCUs internal RC oscillator accuracy*, 2018